# EUROPEAN PATENT APPLICATION

(11) **EP 1 734 501 A1**
(43) Date of publication of application: **20.12.2006**
(21) Application number: 04720165.2
(22) Date of filing: 12.03.2004
(51) Int. Cl.: G09G 3/30, G09F 9/46

(54) **DISPLAY AND METHOD FOR DRIVING SAME**

(71) Applicant: FUJITSU LIMITED, Kawasaki-shi, Kanagawa 211-8588 (JP)
(72) Inventor: NAKAYAMA, Masaya, c/o Fujitsu Limited, Kawasaki-shi Kanagawa 2118588 (JP); SATOU, Tasuku, c/o Fujitsu Limited, Kawasaki-shi Kanagawa 2118588 (JP)
(74) Representative: Wiedemann, Peter
(86) International application number: PCT/JP2004/003265
(87) International publication number: WO 2005/088594

(57) **Abstract**

A display apparatus comprises a self-emitting first display device (10) which is in a light transmission state when no image is displayed, and a second display device (40) which is formed on the first display device (10), and is capable of being switched between a light transmission state and a light non-transmission state, wherein an image which is displayed by the first display device and an image which is displayed by the second display device are superposed upon one another to display a prescribed image. By configuring such a display apparatus, a good black color display can be obtained, and a full color display with a good contrast can be provided even if the surrounding light is intense. In addition, by causing the display device (40) to provide a solid black color display, the information on the display surface on the display device (10) side will not be displayed on the display surface on the display device (40) side. Therefore, the privacy and security of the displayed

## Description

### Technical Field

The present invention pertains to a display apparatus and a driving method for the same, and particularly relates to a self-emitting type display apparatus that can be used for window glass, rear-facing displays, and the like, and a driving method for the same.

### Background Art

In recent years, a display apparatus that is rendered transparent in an image non-display state (a transparent display apparatus) has attracted attention as a display apparatus that can be used for window glass and rear-facing displays. A display apparatus that uses a liquid crystal device or a self-emitting electroluminescence (EL) device has been proposed as this kind of display apparatus.

In particular, since the EL device provides good transparency and display quality, it is expected to be applied to transparent display apparatuses. A transparent display apparatus using an EL device is disclosed in, for example, Japanese Patent Application Laid-Open No. 11-339953.

However, with a conventional self-emitting type transparent display apparatus, it has been difficult to obtain a favorable black color display. Generally, when black is to be displayed in a self-emitting type display apparatus, the method used involves causing the device not to emit light (putting it in a non-light-emitting state). However, with a transparent display apparatus, a non-light-emitting region is in a light transmission state, and thus particularly in a location where external environmental factors, including the surrounding light, have a strong influence, it has been difficult to achieve black color display. Therefore, with the conventional self-emitting type transparent display apparatus, black color display has not been successfully achieved, and thus full colorization has been difficult.

The purpose of the present invention is to provide a display apparatus that is capable of good black color display even if external environmental factors, including the surrounding light, have a strong influence, and that is capable of full color display with a good contrast, and a driving method for the same.

### Disclosure of the Invention

According to an aspect of the present invention, a display apparatus is provided that includes a self-emitting type first display device that is in a light transmission state when no image is displayed, and a second display device that is formed on the first display device and is capable of being switched between a light transmission state and a light non-transmission state, wherein an image displayed by the first display device and an image displayed by the second display device are superposed upon one another to display a prescribed image.

In addition, according to another aspect of the present invention, a driving method is provided for a display apparatus that includes a self-emitting type first display device that is in a light transmission state when no image is displayed, and a second display device that is formed on the first display device and is capable of being switched between a light transmission state and a light non-transmission state, wherein an image displayed by the first display device and an image displayed by the second display device are superposed upon one another, whereby a prescribed image is displayed.

In addition, according to still another aspect of the present invention, a driving method is provided for a display apparatus that includes a self-emitting type first display device that is in a light transmission state when no image is displayed; a second display device that is formed on the first display device and is capable of being switched between a light transmission state and a light non-transmission state; and a self-emitting type third display device that is formed on the second display device and is in a light transmission state when no image is displayed, wherein an image displayed by the first display device and an image displayed by the second display device are superposed upon one another, whereby a first prescribed image is displayed, and an image displayed by the third display device and an image displayed by the second display device are superposed upon one another, whereby a second prescribed image is displayed.

### Brief Description of the Drawings

Fig. 1 is a schematic sectional view illustrating the structure of the display apparatus according to the first embodiment of the present invention;
Figs. 2A, 2B and 2C are drawings illustrating a first driving method for the display apparatus according to the first embodiment of the present invention;
Figs. 3A, 3B and 3C are drawings illustrating a second driving method for the display apparatus according to the first embodiment of the present invention;
Fig. 4 is a schematic sectional view illustrating the structure of the display apparatus according to the second embodiment of the present invention;
Fig. 5 is a schematic sectional view illustrating the structure of the display apparatus according to the third embodiment of the present invention;
Fig. 6 is a schematic sectional view illustrating the structure of the display apparatus according to the fourth embodiment of the present invention;
Figs. 7A, 7B and 7C are drawings illustrating the operation of the electrophoresis type display;
Fig. 8 is a schematic sectional view illustrating the structure of the display apparatus according to the fifth embodiment of the present invention; and
Fig. 9 is a schematic sectional view illustrating the structure of the display apparatus according to the sixth embodiment of the present invention.

### Best Mode for Carrying Out the Invention

### [First embodiment]

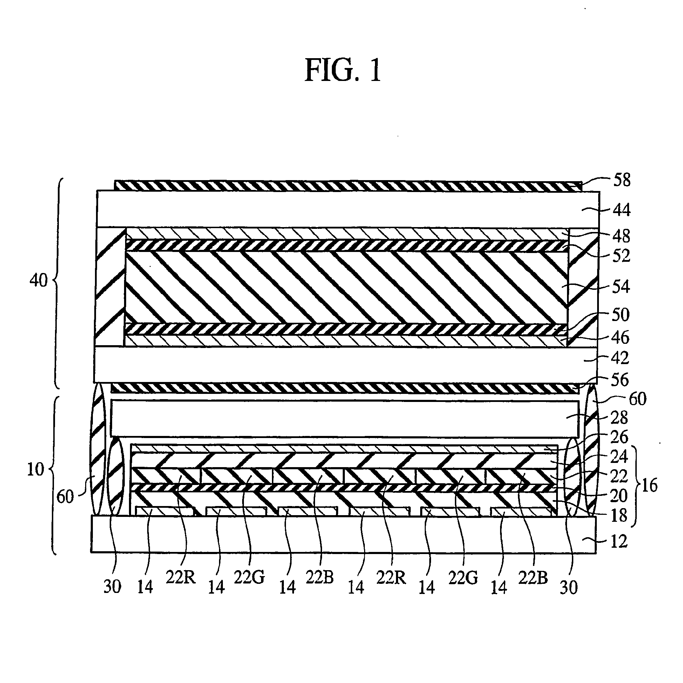

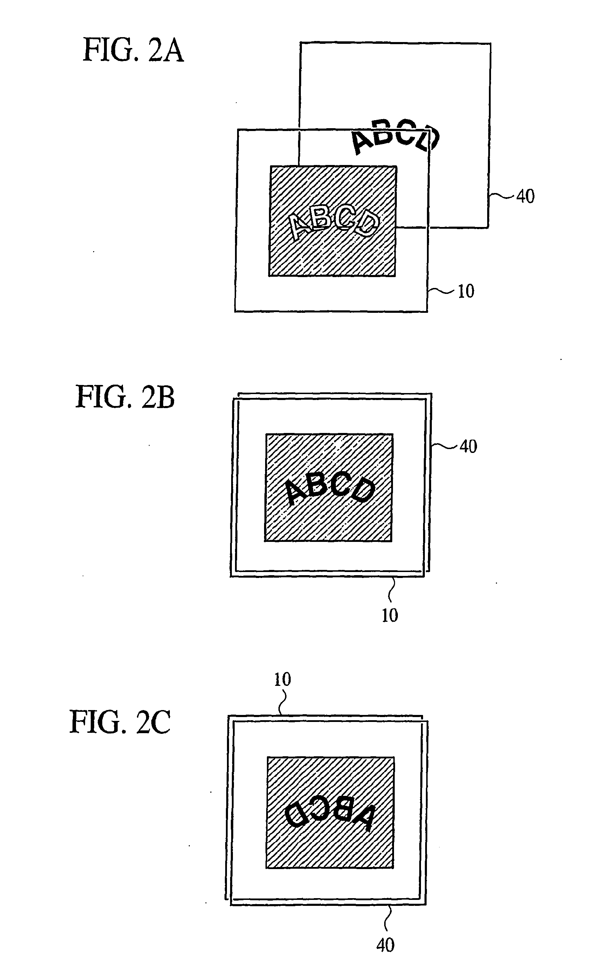

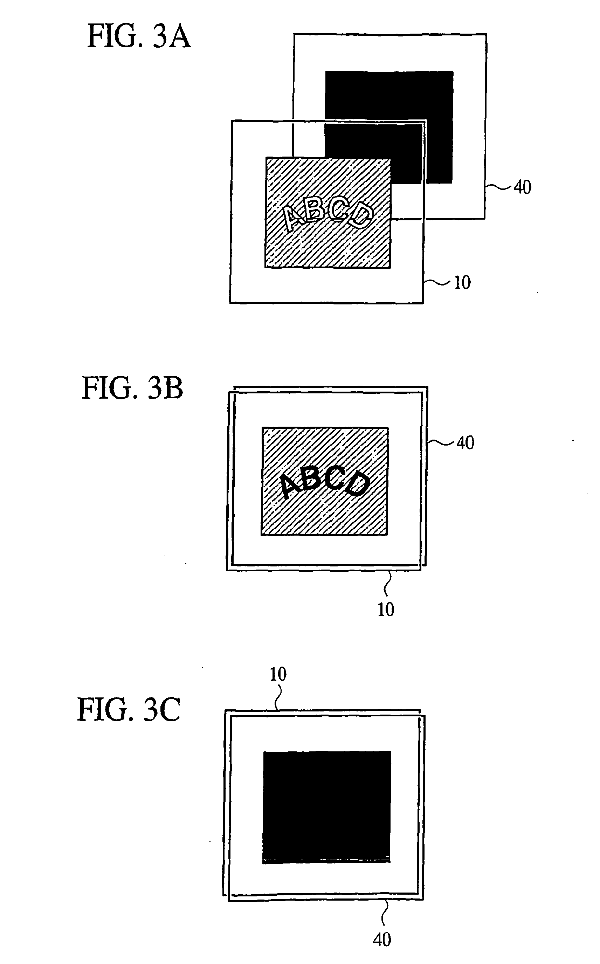

The transparent display apparatus according to a first embodiment of the present invention will be described with reference to Fig. 1 to Fig. 3C. Fig. 1 is a schematic sectional view illustrating the structure of the display apparatus according to the present embodiment, and Fig. 2A, Fig. 2B, and Fig. 2C, and Fig. 3A, Fig. 3B, and Fig. 3C are drawings illustrating the driving method for the display apparatus according to the present embodiment.

Firstly, the structure of the display apparatus according to the present embodiment will be described with reference to Fig. 1.

The display apparatus according to the present embodiment is a transparent display apparatus which is capable of black color display, being configured by combining a self-emitting type transparent display device with a transparent display device which is capable of black color display (providing a light non-transmission state). As the self-emitting type transparent display device, a transparent type organic EL display 10 is used, while, as the transparent display device which is capable of black color display, a transparent type liquid crystal display 40 is used. As shown in Fig. 1, the organic EL display 10 and the liquid crystal display 40 are superposed upon one another such that the corresponding positions of the pixels for the respective display devices are aligned to each other, and laminated to each other by using, for example, an epoxy resin-based adhesive 60.

The organic EL display 10 is formed on a transparent substrate 12 made up of a transparent material, such as glass, quartz, resin, or the like. On the transparent substrate 12, a transparent electrode 14 made up of a transparent material, for example, an ITO layer having a film thickness of 150 nm is formed. The transparent electrodes 14 are discretely provided in correspondence with the respective pixel regions.

On the transparent electrode 14, a luminescence layer 16 made up of an organic EL material is formed. The luminescence layer 16 has a hole injection layer 18 formed on the transparent electrode 14; a hole transportation layer 20 formed on the hole injection layer 18; a luminous body layer 22 formed on the hole transportation layer 20, and an electron transportation layer 24 formed the luminous body layer 22.

The hole injection layer 18 is constituted by, for example, a 2TNATA layer having a film thickness of 200 nm. The hole transportation layer 20 is constituted by, for example, an - NPD layer having a film thickness of 20 nm. The electron transportation layer 24 is constituted by, for example, an Alq layer having a film thickness of 20 nm.

The luminous body layer 22 is constituted by any layer of a red luminous body layer 22R, a green luminous body layer 22G, and a blue luminous body layer 22B for each pixel. The red luminous body layer 22R is constituted by, for example, an Alq layer having a film thickness of 30 nm that is doped with DCM by 1%. The green luminous body layer 22 is constituted by, for example, a TYG-201 layer having a film thickness of 30 nm. The blue luminous body layer 22B is constituted by a laminated film of, for example, a CBP layer having a film thickness of 20 nm that is doped with BAlq by 5%, and, for example, a BCP layer having a film thickness of 10 nm.

On the luminescence layer 16, a rear face electrode 26 made up of a transparent electrode material, such as ITO, or the like, or a translucent electrode material, such as Li, Mg, Al, or the like, is formed. The rear face electrode 26 is constituted by a laminated film of, for example, an MgAg film having a film thickness of 15 nm, and, for example, an ITO film having a film thickness of 150 nm. The rear face electrode 26 is an electrode common to the respective pixel parts.

On the transparent substrate 12 on which the transparent electrode 14, the luminescence layer 16, and the rear face electrode 26 are formed, a seal plate 28 made up of, for example, glass is formed. The seal plate 28 is provided for protecting the luminescence layer 16 made up of an organic EL material against the surrounding atmosphere including oxygen, hydrogen, and the like. Between the transparent substrate 12 and the seal plate 28, sealing is provided by using, for example, an epoxy resin-based adhesive 30, or the like, to laminate each other in a nitrogen gas atmosphere. In this case, by placing a getter agent for water trapping between the transparent substrate 12 and the seal plate 28, the protection against the surrounding atmosphere is rendered reliable. Moreover, it is preferable to use a transparent liquid getter agent.

The liquid crystal display 40 is formed of a pair of transparent substrates 42, 44 made up of a transparent material, such as glass, quartz, resin, or the like. On the opposite faces of the respective transparent substrates 42, 44, transparent electrodes 46, 48 made up of a transparent electrode material, such as ITO, or the like, are formed, respectively. At least one of the transparent electrodes 46, 48 is partitioned into pixels such that a voltage can be applied to each pixel with a wiring (not shown). On the transparent electrodes 46, 48, orientation films 50, 52 are formed, respectively. The orientation films 50, 52 are provided to orient the liquid crystal molecules toward a prescribed direction, and are formed by rubbing, for example, a polyimide film with a nylon cloth in a definite direction. Between the orientation films 50, 52, a liquid crystal 54 (for example, MJ95785 manufactured by Merck Ltd., Japan) is filled.

On the non-opposite faces of the transparent substrates 42, 44, polarization plates 56, 58 are formed, respectively. With the polarization plate 56, 58, a polarization layer made up of, for example, a polyvinyl alcohol-iodine system is sandwiched between plastic films, and the polarization plates 56, 58 are disposed such that, when no voltage is applied across the transparent electrodes 46, 48 (at the time of power being OFF), light is transmitted (the polarization plates 56, 58 being rendered transparent), and when a voltage is applied across the transparent electrodes 46, 48 (at the time of power being ON), non-transmission (black color display) is caused.

Next, the driving method for the display apparatus according to the present embodiment will be described specifically with reference to Fig. 2 and Fig. 3. As the driving method for the display apparatus according to the present embodiment, two different methods as described below, for example, can be conceived.

### (Driving method 1)

The present driving method simultaneously drives the corresponding pixels in the organic EL display 10 and the liquid crystal display 40. And, as shown in Fig. 2A, the organic EL display 10 displays the color display part of the display image excluding the black color portion. On the other hand, the liquid crystal display 40 displays only the black color portion of the display image.

By using this driving method, on the display surface of the organic EL display 10 side, the image displayed by the organic EL display 10 is superposed on the image displayed by the liquid crystal display 40, resulting in an image as shown in Fig. 2B being displayed. In addition, on the display surface of the liquid crystal display 10 side, the image displayed by the liquid crystal display 40 is superposed on the image displayed by the organic EL display 10, resulting in an image as shown in Fig. 2C being displayed.

Thus, the display apparatus according to the present embodiment provides a full color double-side light emitting type display apparatus. In this cae, when an image as shown in, for example, Fig. 2B is displayed on one display surface, an image as shown in, for example, Fig. 2C, which is symmetric to the image on the one display surface, is displayed on the other display surface.

### (Driving method 2)

As shown in Fig. 3A, the organic EL display 10 displays the color display part of the display image excluding the black color portion. The liquid crystal display 40 provides a solid black color display over the entire image region. With the present driving method, there is no need for simultaneously performing the display on the liquid crystal display 40 and the driving of the organic EL display 10.

By using this driving method, on the display surface of the organic EL display 10 side, the image displayed by the organic EL display 10 is superposed on the image displayed by the liquid crystal display 40, resulting in an image as shown in Fig. 3B being displayed. On the other hand, on the display surface on the liquid crystal display 10 side, the image displayed by the organic EL display 10 is completely shielded by the image displayed by the liquid crystal display 40, thus an image as shown in Fig. 3C is displayed.

Thus, with the present driving method, a full color image is displayed on the display surface on the organic EL display 10 side (see Fig. 3B), but on the display surface on the liquid crystal display 40 side, a solid black color display is provided with no image being displayed (see Fig. 3C).

In other words, the present driving method can be said to have an effect of preventing the image information from being viewed by a person who is on the display surface side of the liquid crystal display 40. In other words, with the conventional transparent display apparatus, the display information is displayed on both display surfaces of the display apparatus, thus there are problems with privacy and security, however, by using the present driving method, the display information is displayed only on one surface side of the display apparatus. Therefore, according to the display apparatus of the present embodiment, the privacy and security of the display information can be protected.

A display apparatus according to the present embodiment was manufactured, and an operation test thereof was carried out to find that, when normal mode (when the power is turned OFF), it is rendered transparent, and at the time of image display, a full color display with a good contrast could be performed. In addition, when the above-described driving method 1 was used, an image could be confirmed on both display surfaces. In addition, when the above-described driving method 2 was used, the display surface on the liquid crystal display side gave a black color display with no image being viewed.

Thus, according to the present embodiment, a self-emitting type transparent display device is combined with a transparent display device which is capable of displaying black color, for constituting a display apparatus, so that a good black color display can be obtained, even if the surrounding light is intense, to provide a full color display with a good contrast.

In addition, by causing the transparent display device which is capable of displaying black color to provide a solid black color display, the information on the display surface on the self-emitting type transparent display device side is not displayed on the display surface on the side of the transparent display device which is capable of displaying black color. Therefore, the privacy and security of the display information can be protected.

### [Second embodiment]

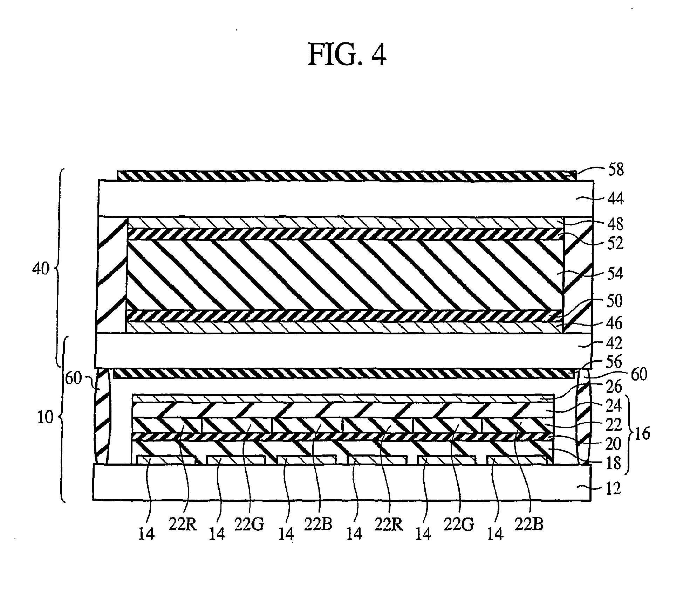

The display apparatus and the driving method for the apparatus according to a second embodiment of the present invention will be described with reference to Fig. 4. For the same components as those of the display apparatus and the driving method for the apparatus according to the first embodiment as shown in Fig. 1 to Fig. 3, the same numerals and signs will be provided with the explanation being omitted or simplified.

Fig. 4 is a schematic sectional view illustrating the structure of the display apparatus according to the present embodiment.

Like the display apparatus according to the first embodiment, the display apparatus according to the present embodiment is a transparent display apparatus constituted by combining a self-emitting type transparent display device with a transparent display device which is capable of black color display, and as the self-emitting type transparent display device, a transparent type organic EL display 10 is used, and as the transparent display device which is capable of displaying black color, a transparent type liquid crystal display 40 is used.

The display apparatus according to the present embodiment mainly features that, as shown in Fig. 4, the transparent substrate 42 in the liquid crystal display 40 constitutes a seal plate for sealing the luminescence layer 16 in the organic EL display 10.

In the case of the display apparatus according to the first embodiment as shown in Fig. 1, in order to increase the transmittance for the display apparatus as a whole, it is desirable that, in laminating the organic EL display 10 and the liquid crystal display 40 to each other, a substance having an index of refraction equivalent to the index of refraction for the seal plate 28 and the transparent substrate 42 intervenes therebetween in the laminated portion. Therefore, in the case of the display apparatus according to the first embodiment as shown in Fig. 1, it is conceived to place a substance having such an index of refraction between the seal plate 28and the transparent substrate 42.

On the other hand, with the display apparatus according to the present embodiment, in order to obtain an effect equivalent or superior to that by this scheme for the first embodiment, the transparent substrate 42 in the liquid crystal display 40 constitutes a seal plate for sealing the luminescence layer 16 in the organic EL display 10. By thus constituting the display apparatus, the variation in index of refraction between the organic EL display 10 and the liquid crystal display 40 in the laminated portion is eliminated, which allows the transmittance of the display apparatus as a whole to be greatly improved.

The above-described constitution provides various advantages in addition to the advantage on display quality. For example, without the process for laminating the seal plate, the process for laminating the organic EL display 10 and the liquid crystal display 40 to each other can be performed by a single process, thus the manufacturing process is simplified, which allows the manufacturing cost to be reduced. In addition, because the seal plate 28 is not required, the number of components is reduced, which allows the product cost to be reduced. Further, the display apparatus can be thinned by the thickness equivalent to that of the seal plate 28.

Thus, according to the present embodiment, the transparent substrate for the liquid crystal display is used as the seal plate for the organic EL display, thus the loss in transmitted light in the laminated portion between the organic EL display 10 and the liquid crystal display 40 can be prevented. Thereby, the transmittance of the display apparatus as a whole can be greatly improved. In addition, the number of manufacturing processes and the number of components are reduced, which can lower the manufacturing cost and thus the product cost.

### [Third embodiment]

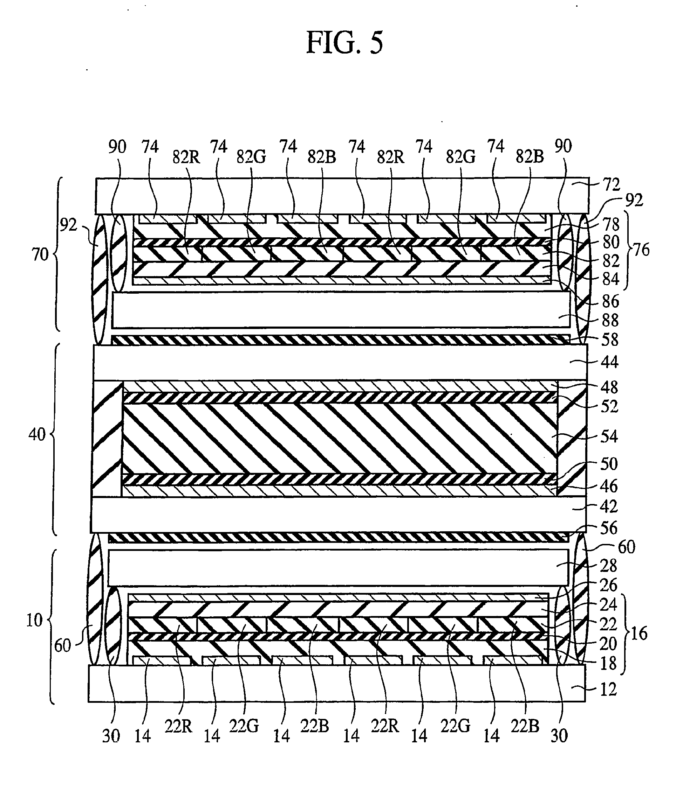

The display apparatus and the driving method for the apparatus according to a third embodiment of the present invention will be described with reference to Fig. 5. For the same components as those of the display apparatus and the driving method for the apparatus according to the first and second embodiments as shown in Fig. 1 to Fig. 4, the same numerals and signs will be provided with the explanation being omitted or simplified.

Fig. 5 is a schematic sectional view illustrating the structure of the display apparatus according to the present embodiment.

Firstly, the structure of the display apparatus according to the present embodiment will be described with reference to Fig. 5.

The display apparatus according to the present embodiment features that, unlike the display apparatus according to the first embodiment as shown in Fig. 1, a transparent type organic EL display 70 as the self-emitting type transparent display device is further laminated to the transparent substrate 44 side of the liquid crystal display 40. In other words, the organic EL display 10 and the organic EL display 70 are provided such that they sandwich the liquid crystal display 40.

As shown in Fig. 5, the transparent type organic EL display 70, the organic EL display 10, and the liquid crystal display 40 are superposed one upon another such that the corresponding positions of the pixels for these are aligned to one another, and laminated to one another by using, for example, an epoxy resin-based adhesive 92.

The organic EL display 70 is formed on a transparent substrate 72 made up of a transparent material, such as glass, quartz, resin, or the like. On the transparent substrate 72, a transparent electrode 74 made up of a transparent material, for example, an ITO layer having a film thickness of 150 nm is formed. The transparent electrodes 74 are discretely provided in correspondence with the respective pixel regions.

On the transparent electrode 74, a luminescence layer 76 made up of an organic EL material is formed. The luminescence layer 76 has a hole injection layer 78 formed on the transparent electrode 74; a hole transportation layer 80 formed on the hole injection layer 78; a luminous body layer 82 formed on the hole transportation layer 80, and an electron transportation layer 84 formed the luminous body layer 82.

The hole injection layer 78 is constituted by, for example, a 2TNATA layer having a film thickness of 200 nm. The hole transportation layer 80 is constituted by, for example, an -NPD layer having a film thickness of 20 nm. The electron transportation layer 84 is constituted by, for example, an Alq layer having a film thickness of 20 nm.

The luminous body layer 82 is constituted by any layer of a red luminous body layer 82R, a green luminous body layer 82G; and a blue luminous body layer 82B for each pixel. The red luminous body layer 82R is constituted by, for example, an Alq layer having a film thickness of 30 nm that is doped with DCM by 1%. The green luminous body layer 82G is constituted by, for example, a TYG-201 layer having a film thickness of 30 nm. The blue luminous body layer 82B is constituted by a laminated film of, for example, a CBP layer having a film thickness of 20 nm that is doped with BAlq by 5%, and, for example, a BCP layer having a film thickness of 10 nm.

On the luminescence layer 76, a rear face electrode 86 made up of a transparent electrode material, such as ITO, or the like, or a translucent electrode material, such as Li, Mg, Al, or the like, is formed. The rear face electrode 86 is constituted by a laminated film of, for example, an MgAg film having a film thickness of 15 nm, and, for example, an ITO film having a film thickness of 150 nm. The rear face electrode 86 is an electrode common to the respective pixel parts.

On the transparent substrate 72 on which the transparent electrode 74, the luminescence layer 76, and the rear face electrode 86 are formed, a seal plate 88 made of, for example, glass is formed. The seal plate 88 is provided for protecting the luminescence layer 76 made up of an organic EL material against the surrounding atmosphere including oxygen, hydrogen, and the like. Between the transparent substrate 72 and the seal plate 88, sealing is provided by using, for example, an epoxy resin-based adhesive 90, or the like, to affix them to each other in a nitrogen gas atmosphere. In this case, by placing a getter agent for water trapping between the transparent substrate 12 and the seal plate 88, the protection against the surrounding atmosphere is rendered reliable. Moreover, it is preferable to use a transparent liquid getter agent.

Next, the driving method for the display apparatus according to the present embodiment will be described specifically.

As the driving method for the display apparatus according to the present embodiment, two different methods as described below, for example, can be conceived.

### (Driving method 1)

According to the present driving method, the corresponding pixels in the organic EL display 10, the liquid crystal display 40, and the organic EL display 70 are simultaneously driven. The organic EL displays 10, 70 display the color display part of the display image excluding the black color portion. On the other hand, the liquid crystal display 40 displays only the black color portion of the display image.

By using this driving method, the display apparatus according to the present embodiment provides a full color double-side light emitting type display apparatus. In addition, with the display apparatus according to the present embodiment, an organic EL display 10 is disposed on one display surface side, and on the other display surface side, an organic EL display 70 is disposed, thus an equivalent brightness is obtained on both display surfaces. However, as with the driving method 1 for the display apparatus according to the first embodiment, the image which is displayed on one display surface, and the image which is displayed on the other display surface are symmetric to each other.

### (Driving method 2)

With the present driving method, the organic EL display 10, 70 displays the color display part of the display image excluding the black color portion. The liquid crystal display 40 provides a solid black color display over the entire image region. With the present driving method, there is no need for simultaneously performing the display on the liquid crystal display 40 and the driving of the organic EL displays 10, 70.

By using this driving method, on the display surface of the organic EL display 10 side and the display surface on the organic EL display 70 side, full color images are displayed, respectively.

In addition, causing the liquid crystal display 40 to provide black color display over the entire display image region as with the present driving method also brings about an effect that the image displayed on the organic EL display 10 and the image displayed on the organic EL display 70 are completely separated from each other.

Therefore, the image displayed on the organic EL display 10 and the image displayed on the organic EL display 70 need not always be images which correspond to each other. For example, the image displayed on the organic EL display 10 and the image displayed on the organic EL display 70 may be the same as each other, may be symmetric to each other, or may be images which are quite different from each other. Or, if either one of the organic EL display 10 and the organic EL display 70 is not driven, the driving equivalent to that by the driving method 2 for the display apparatus according to the first embodiment can be performed.

A display apparatus according to the present embodiment was manufactured, and an operation test thereof was carried out to find that, when normal mode (when the power is turned OFF), it is rendered transparent, and at the time of image display, a full color display with a good contrast can be performed. In addition, when the above-described driving method 1 was used, an image could be confirmed on the both display surfaces. In addition, when the above-described driving method 2 was used, the organic EL displays 10, 70 could display separate images, respectively, and different images could be displayed with a good contrast on the both surfaces.

Thus, according to the present embodiment, a self-emitting type transparent display device is combined with a transparent display device which is capable of displaying black color, for configuring a display device, which allows a good black color display to be obtained, even if the surrounding light is intense, and a full color display with a good contrast to be provided.

In addition, on the both display surface sides, a self-emitting type transparent display device is provided, thus different pieces of information can be displayed on the rear and front of the same display apparatus. In addition, the display information can be prevented from being inverted at the rear and front of the same display apparatus.

### [Fourth embodiment]

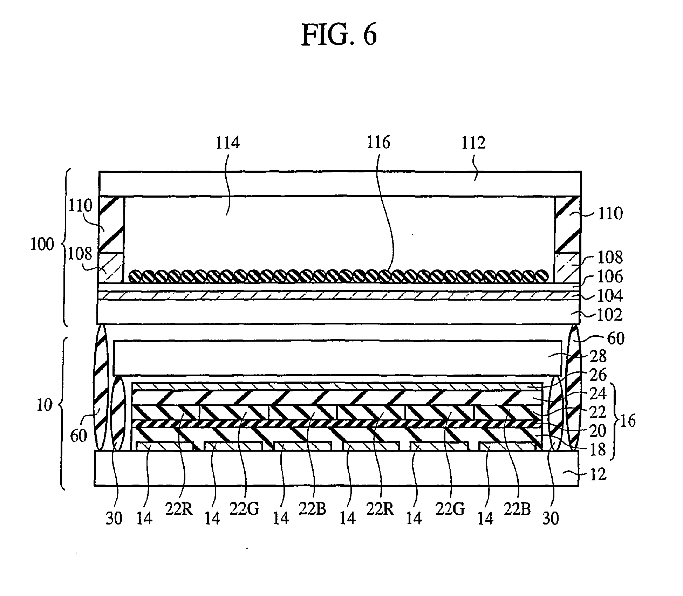

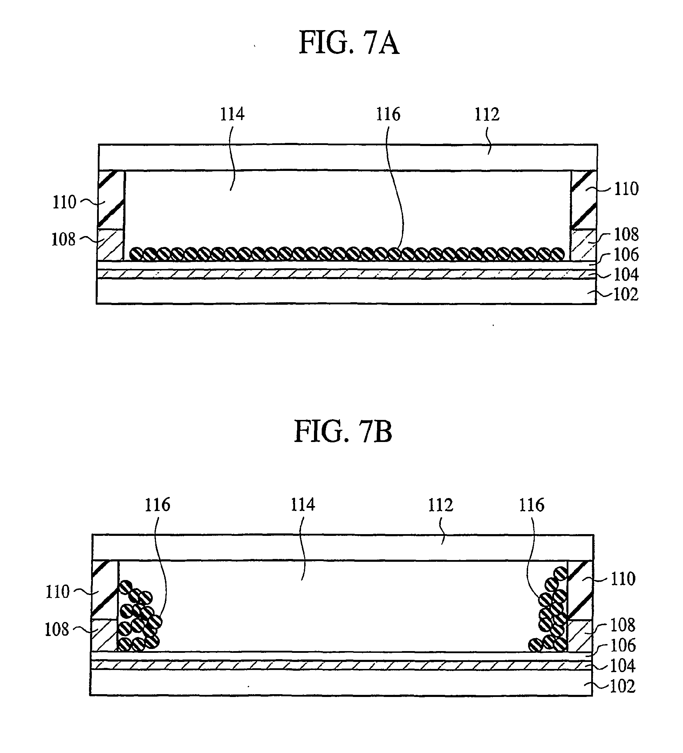

The display apparatus and the driving method for the apparatus according to a fourth embodiment of the present invention will be described with reference to Fig. 6 and Fig. 7. For the same components as those of the display apparatus and the driving method for the apparatus according to the first to third embodiments as shown in Fig. 1 to Fig. 5, the same numerals and signs will be provided with the explanation being omitted or simplified.

Fig. 6 is a schematic sectional view illustrating the structure of the display apparatus according to the present embodiment, and Fig. 7 is drawings illustrating the operation of the electrophoresis type display 100.

In the display apparatuses according to the above-described first to third embodiments, a transparent type liquid crystal display has been used as the transparent display device which is capable of displaying black color, however, in place of the transparent type liquid crystal display, any other adequate type of transparent display device can also be applied.

With the display apparatus according to the present embodiment, as shown in Fig. 6, an electrophoresis type display 100 is formed in place of the liquid crystal display 40 in the display apparatus according to the first embodiment. The electrophoresis type display is stated in, for example, Japanese Patent Application Laid-Open No. 2003-161966.

The electrophoresis type display 100 is formed on a transparent substrate 102 made up of glass, quartz, resin, or the like. On the transparent substrate 102, a transparent electrode 104 made up of, for example, an ITO film, and a transparent insulation layer 106, made up of, for example, a silicon nitride film. On the transparent insulation layer 106, an electrode 108 made up of, for example, aluminum is formed. To the transparent insulation layer 106 on which the electrode 108 is formed, a transparent substrate 112 is laminated through a partition wall/spacer 110. Between the transparent insulation layer 106 and the transparent substrate 112, a liquid 114 having insulation properties and transparency (for example, silicone oil) is filled. In this liquid, an appropriate amount of charged electrophoretic particles 116, for example, positively charged, are dispersed.

Next, the operation of the electrophoresis type display 100 will be described with reference to Fig. 7.

When a negative charge with respect to the electrode 108 is applied to the transparent electrode 104, the charged electrophoretic particles 116 are attracted to the transparent electrode 104, being moved in the liquid 114 to the transparent insulation layer 106 on the transparent electrode 104. Thereby, the pixel part is fully covered with the charged electrophoretic particles 116 to provide a black color display (Fig. 7A).

On the other hand, when a negative charge with respect to the transparent electrode 104 is applied to the electrode 108, the charged electrophoretic particles 114 are attracted to the electrode 108, being moved in the liquid 114 to near the partition wall/spacer 110. Thereby, the pixel part is emptied of the charged electrophoretic particles 116 to be rendered transparent (Fig. 7 B).

Therefore, the electrophoresis type display 100 as shown in Fig. 6 is also capable of making transparent and displaying black color, as with the liquid crystal display 40, and the display apparatus according to the present embodiment can also be driven by the same method as the driving method for the display apparatus according to the first embodiment.

Thus, also by using the electrophoresis type display as a transparent display device which is capable of displaying black color, in accordance with the present embodiment, a display apparatus which is capable of displaying full color with a good contrast even if the surrounding light is intense can be constructed.

### [Fifth embodiment]

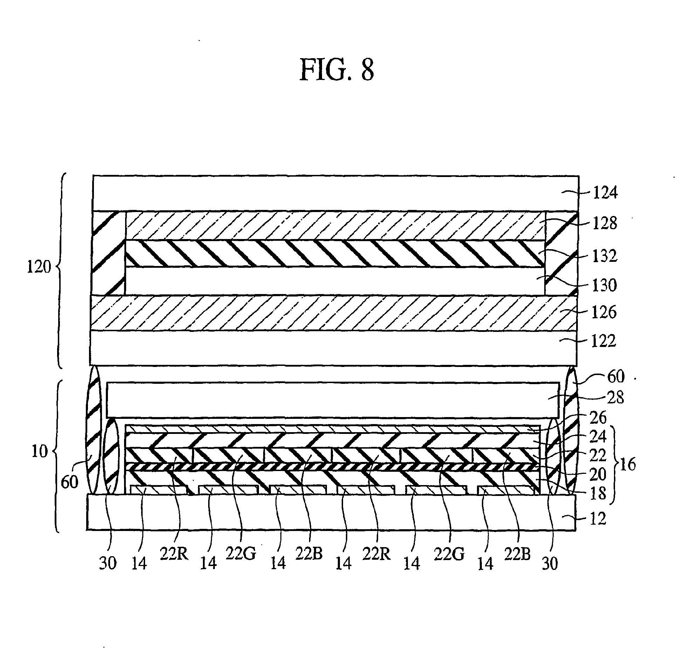

The display apparatus and the driving method for the apparatus according to a fifth embodiment of the present invention will be described with reference to Fig. 8. For the same components as those of the display apparatus and the driving method for the apparatus according to the first to third embodiments as shown in Fig. 1 to Fig. 5, the same numerals and signs will be provided with the explanation being omitted or simplified.

Fig. 8 is a schematic sectional view illustrating the structure of the display apparatus according to the present embodiment.

In the display apparatuses according to the above-described first to third embodiments, a transparent type liquid crystal display has been used as the transparent display device which is capable of displaying black color, however, in place of the transparent type liquid crystal display, any other adequate type of transparent display device can be applied.

With the display apparatus according to the present embodiment, as shown in Fig. 8, an electrochromic light control glass 120 is formed in place of the liquid crystal display 40 in the display apparatus according to the first embodiment. The electrochromic light control glass is stated in, for example, Japanese Patent Application Laid-Open No. 2002-268096.

The electrochromic light control glass 120 has a pair of transparent substrates 122, 124 comprises glass, quartz, resin, or the like. On the non-opposite faces of the transparent substrates 122, 124, a transparent electrode 126, 128 made up of, for example, an ITO film is formed, respectively. Between the transparent substrates 126, 128, an electrolyte layer 130 and an electrochromic layer 132 are sandwiched.

For the electrochromic layer 132, a reduction color-forming type material, such as V2O5, Nb2O5, TiO2, WO3, or the like, or an oxidation color-forming type material, such as NiO, Cr2O3, MnO2, CoO, or the like is used. For the electrolyte layer 130, a composition with which a carrier electrolyte is dissolved/mixed into a polar solvent is generally used.

In the case where, for example, a reduction color-forming type material is used for the electrochromic layer 132, application of a voltage such that the transparent electrode 126 provides the positive electrode, and the transparent electrode 128 provides the negative electrode will render this electrochromic light control glass 120 transparent. Inversely, application of a voltage such that the transparent electrode 126 provides the negative electrode, and the transparent electrode 128 provides the positive electrode will render this electrochromic light control glass 120 opaque (black).

Therefore, the electrochromic light control glass 120 as shown in Fig. 8 is also capable of making transparent and displaying black color in the same manner as the liquid crystal display 40, and the display apparatus according to the present embodiment can also be driven by the same method as the driving method for the display apparatus according to the first embodiment.

Thus, also by using the electrochromic light control glass as a transparent display device which is capable of displaying black color, in accordance with the present embodiment, a display apparatus which is capable of displaying full color with a good contrast even if the surrounding light is intense can be structured.

### [Sixth embodiment]

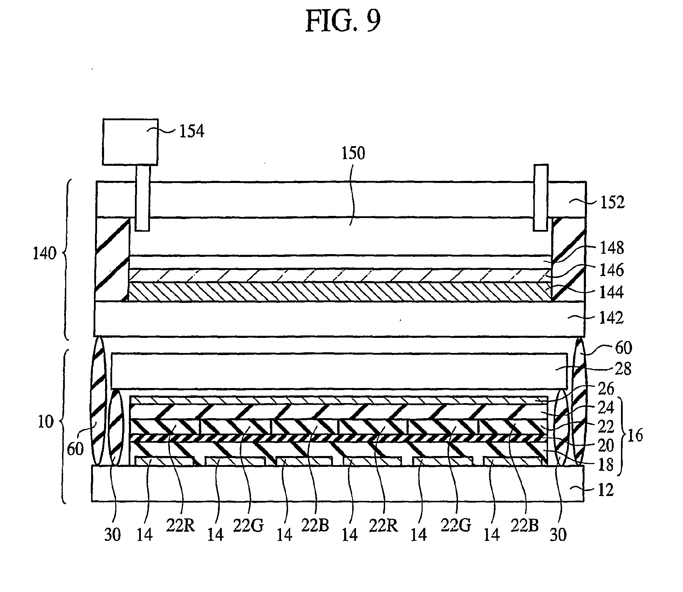

The display apparatus and the driving method for the apparatus according to a sixth embodiment of the present invention will be described with reference to Fig. 9. For the same components as those of the display apparatus and the driving method for the apparatus according to the first to third embodiments as shown in Fig. 1 to Fig. 5, the same numerals and signs will be provided with the explanation being omitted or simplified.

Fig. 9 is a schematic sectional view illustrating the structure of the display apparatus according to the present embodiment.

In the display apparatuses according to the above-described first to third embodiments, a transparent type liquid crystal display has been used as the transparent display device which is capable of displaying black color, however, in place of the transparent type liquid crystal display, any other adequate type of transparent display device can be applied.

With the display apparatus according to the present embodiment, as shown in Fig. 9, a gas-chromic light control glass 140 is formed in place of the liquid crystal display 40 in the display apparatus according to the first embodiment. The gas-chromic light control glass is stated in, for example, Japanese Patent Application Laid-Open No. 2003-261356.

The gas-chromic light control glass 140 is formed on a transparent substrate 142 made up of glass, quartz, resin, or the like. On the transparent substrate 142, a magnesium thin film 144 having a film thickness of 40 nm or under is formed. On the magnesium thin film 144, a catalyst layer 146 made up of, for example, palladium or platinum is formed. On the catalyst layer 146, a protection layer 148 made up of a material, for example, a tantalum oxide thin film, a zirconium oxide thin film, or the like, which is permeable to hydrogen, and is non-permeable to water is formed. On the protection layer 148, a transparent substrate 152 is formed through a gap 150. In addition, an atmosphere controller 154 which introduces the hydrogen gas and the oxygen gas into the gap 150 is provided such that the degree of hydrogenation and dehydrogenation can be adjusted.

In the case of this gas-chromic light control glass, when the gas to be introduced into the gap 150 from the atmosphere controller 154 is adjusted to hydrogenate the magnesium thin film 144, it is rendered transparent, while, when dehydrogenated, it is rendered opaque (put in a mirror state).

Therefore, as shown in Fig. 9, the gas-chromic light control glass 140 is also capable of making transparent and displaying black color in the same manner as the liquid crystal display 40, and the display apparatus according to the present embodiment can also be driven by the same method as the driving method for the display apparatus according to the first embodiment.

Thus, also by using the gas-chromic light control glass as a transparent display device which is capable of black color display, in accordance with the present embodiment, a display apparatus which is capable of full color display with a good contrast even if the surrounding light is intense can be configured.

### [Variant embodiment]

The present invention is not limited to the above-described embodiments, and various modifications can be made.

For example, in the above-described third embodiment, the seal plate 28, 88 has been provided for the organic EL display 10, 70, respectively, however, as is the case with the display apparatus according to the second embodiment, the third embodiment may be adapted such that the transparent substrate 42 in the liquid crystal display 40 also serves as the seal plate for the organic EL display 10, and/or the transparent substrate 44 in the liquid crystal display 40 also serves as the seal plate for the organic EL display 70.

In addition, in the above-described fourth to sixth embodiments, the cases where, in place of the liquid crystal display 40 in the display apparatus in the first embodiment, other types of transparent display device are used have been described, however, also in the second and third embodiments, those other types of transparent display device can be applied.

In addition, in the above-described embodiments, a transparent type organic EL display has been used as the self-emitting type transparent display device, however, as the self-emitting type transparent display device, any other adequate type of display device may be applied. For example, an inorganic EL device may be used to configure the display apparatus of the present invention.

In addition, in the above-described embodiments, as the transparent display device which is capable of displaying black color, a liquid crystal display, an electrophoresis type display, an electrochromic light control glass, and a gas-chromic light control glass have been used, however, the above-described embodiments may be adapted such that any other type of display is applied, provided that it is capable of being switched between the light transmission state and the non-transmission one. As the transparent display device which is capable of displaying black color, it is particularly preferable to use that which is controllable only with the electric field (resulting in the power consumption being substantially zero).

### Industrial Applicability

The display apparatus according to the present invention and the driving method for the apparatus realize a full color display with a good contrast that is unsusceptible to the influence of external environmental factors, including the surrounding light, and provide protection of the privacy and security of the displayed information. Therefore, the display apparatus according to the present invention and the driving method for the apparatus is extremely useful in application to window glass televisions, window glass advertising display apparatuses, transparent televisions, transparent advertising display apparatuses, transparent PC monitors, portable telephone displays, and the like.

## Claims

1. A display apparatus, comprising a self-emitting first display device that is in a light transmission state when no image is displayed, and a second display device that is formed on the first display device, and is capable of being switched between a light transmission state and a light non-transmission state, wherein
an image displayed by the first display device and an image displayed by the second display device are superposed upon one another to display a prescribed image.

2. The display apparatus of claim 1, wherein
the first display device puts a black color display portion of the prescribed image in a light transmission state, and
the second display device puts the black color display portion of the prescribed image into a light non-transmission state.

3. The display apparatus of claim 1, wherein
the first display device puts a black color display portion of the prescribed image in a light transmission state, and
the second display device puts an entire display region into a light non-transmission state.

4. The display apparatus of claim 1, further comprising a self-emitting third display device that is formed on the second display device and is in a light transmission state when no image is displayed, wherein
an image displayed by the first display device and an image displayed by the second display device are superposed upon one another to display a first prescribed image, and
an image displayed by the third display device and an image displayed by the second display device are superposed upon one another to display a second prescribed image.

5. The display apparatus of claim 4, wherein
the first display device puts a black color display portion of the first prescribed image in a light transmission state,
the third display device puts a black color display portion of the second prescribed image in a light transmission state, and
the second display device puts the black color display portion of the first prescribed image and the second prescribed image in a light non-transmission state.

6. The display apparatus of claim 4, wherein
the first display device puts a black color display portion of the first prescribed image in a light transmission state,
the third display device puts a black color display portion of the second prescribed image in a light transmission state, and
the second display device puts an entire display region in a light non-transmission state.

7. The display apparatus of any one of claims 1 to 6, wherein
a transparent substrate used in the first display device is the same substrate as one transparent substrate of a pair of transparent substrates structuring the second display device.

8. The display apparatus of any one of claims 4 to 6, wherein
a transparent substrate used in the first display device is the same substrate as one transparent substrate of a pair of transparent substrates structuring the second display device, and
a transparent substrate used in the third display device is the same substrate as the other transparent substrate of the pair of transparent substrates structuring the second display device.

9. The display apparatus of any one of claims 1 to 8, wherein
the first and third display devices are display devices using an electroluminescence device.

10. The display apparatus of any one of claims 1 to 9, wherein
the second display device is a liquid crystal display, an electrophoresis display, an electrochromic light control glass, or a gas-chromic light control glass.

11. A driving method for a display apparatus comprising a self-emitting first display device that is in a light transmission state when no image is displayed and a second display device that is formed on the first display device and is capable of being switched between a light transmission state and a light non-transmission state, wherein
an image displayed by the first display device and an image displayed by the second display device are superposed upon one another, whereby a prescribed image is displayed.

12. The driving method for a display apparatus of claim 11, wherein,
a black color display portion of the prescribed image is put in a light transmission state by the first display device, and the black color display portion of the prescribed image is put in a light non-transmission state by the second display device, whereby the prescribed image is displayed.

13. The driving method for a display apparatus of claim 11, wherein,
a black color display portion of the prescribed image is put in a light transmission state by the first display device, and an entire display region is put in a light non-transmission state by the second display device, whereby the prescribed image is displayed.

14. A driving method for a display apparatus comprising a self-emitting first display device that is in a light transmission state when no image is displayed; a second display device that is formed on the first display device and is capable of being switched between a light transmission state and a light non-transmission state; and a self-emitting third display device that is formed on the second display device and is in a light transmission state when no image is displayed, wherein
an image displayed by the first display device and an image displayed by the second display device are superposed upon one another, whereby a first prescribed image is displayed, and
an image displayed by the third display device and an image displayed by the second display device are superposed upon one another, whereby a second prescribed image is displayed.

15. The driving method for a display apparatus of claim 14, wherein,
a black color display portion of the first prescribed image is put in a light transmission state by the first display device, and an entire display region is put in a light non-transmission state by the second display device, whereby the first prescribed image is displayed,
and
a black color display portion of the second prescribed image is put in a light transmission state by the third display device, and the entire display region is put in a light non-transmission state by the second display device, whereby the second prescribed image is displayed.

16. The driving method for a display apparatus of claim 14, wherein,
a black color display portion of the first prescribed image is put in a light transmission state by the first display device, and the black color display portion of the first prescribed image is put in a light non-transmission state by the second display device, whereby the first prescribed image is displayed,
and
a black color display portion of the second prescribed image is put in a light transmission state by the third display device, and the black color display portion of the second prescribed image is put in a light non-transmission state by the second display device, whereby the second prescribed image is displayed.
